Europäisches Patentamt

European Patent Office

Office européen des brevets

(19)

(11) **EP 0 703 583 A1**

(12) ## DEMANDE DE BREVET EUROPEEN

(43) Date de publication:
27.03.1996 Bulletin 1996/13

(51) Int Cl.$^6$: **G11C 7/00**, G11C 11/412,
G11C 17/14, G11C 5/14

(21) Numéro de dépôt: 95401981.6

(22) Date de dépôt: 31.08.1995

(84) Etats contractants désignés:
**DE FR GB**

(30) Priorité: **02.09.1994 FR 9410572**

(71) Demandeur: **COMMISSARIAT A L'ENERGIE
ATOMIQUE
F-75015 Paris (FR)**

(72) Inventeurs:
- **Grenouilloux, Charles
F-93100 Montreuil (FR)**
- **Joffre, Francis
F-91440 Bures-sur-Yvette (FR)**

(74) Mandataire: **Dubois-Chabert, Guy
c/o BREVATOME
25, rue de Ponthieu
F-75008 Paris (FR)**

(54) **Procédé de production de mémoires à accès aléatoire de type statique à préchargement**

(57)     La présente invention concerne un procédé de production d'une mémoire à accès aléatoire de type statique à préchargement, dans lequel on prend une mémoire statique à accès aléatoire de type statique composée de transistors MOS constitutifs de l'ensemble des bascules mémoire, et dans lequel on applique un faisceau de particules ou de photons à ces transistors MOS de manière à ce que la dose cumulée reçue soit supérieure à une valeur déterminée.

FIG. 1

EP 0 703 583 A1

Printed by Jouve (FR), 18, rue Saint-Denis, 75001 PARIS

## Description

Domaine technique

La présente invention concerne un procédé de production de mémoires à accès aléatoire de type statique à préchargement à partir de mémoires à accès aléatoire de type statique.

Etat de la technique antérieure

Il peut être intéressant de disposer de mémoires ayant un contenu prédéfini à la mise sous tension. Ce type de mémoire peut par exemple être utilisé pour des robots ou des automates. Elles contiennent alors un programme, une configuration ou des paramètres susceptibles d'être modifiés par téléchargement ou directement par le calculateur du système. L'avantage réside dans le fait qu'en cas de problèmes de téléchargement, d'erreurs de configuration ou de paramètrage, il reste toujours la possibilité de mettre le circuit hors tension puis sous tension. Le contenu d'origine est alors à nouveau présent en mémoire. Cette réinitialisation de la mémoire peut être confiée à un système de chien de garde.

Ce type de mémoire permet ainsi d'augmenter la fiabilité des systèmes, en donnant la possibilité de retrouver à tout moment et de manière simple le contenu d'origine de la mémoire.

Actuellement, seules quatre sortes de mémoires sont susceptibles d'avoir leur contenu modifié :

- Les PROM à fusibles (mémoires mortes programmables une seule fois par l'utilisateur). Il est toujours possible d'écrire dans ces composants une fois programmés, à condition qu'il reste des endroits non programmés dans le circuit. Cependant, chaque écriture est irréversible. De plus il faut disposer sur le circuit du système de programmation, ce qui complique la conception des systèmes.

- Les EEPROM (mémoires programmables et effaçables électriquement par l'utilisateur) et les RAM à piles (mémoires volatiles maintenues sous tension pour conserver les données). Les composants de ce genre peuvent avoir leur contenu modifié. Cependant, en cas de problèmes, il est impossible de retrouver le contenu d'origine.

- Les NOVRAM (non volatiles RAM). Elles associent une EEPROM et une RAM tampon dans un même boîtier. Elles peuvent être utilisées de la même manière que les RAM à préchargement. Cependant elles n'existent qu'en petite capacité mémoire et leur densité intégration sera toujours plus faible que les RAM, étant donné qu'il faut deux matrices mémoires.

On s'aperçoit qu'il n'existe pas de composant capable de se substituer à une RAM à préchargement. Seuls des systèmes plus complexes comprenant une ROM, une RAM et un circuit logique pourraient permettre d'assurer la même fonction.

L'invention a ainsi pour objet d'obtenir une mémoire à accès aléatoire de type statique à préchargement, en partant d'une mémoire volatile.

Exposé de l'invention

L'invention propose donc un procédé de production d'une mémoire à accès aléatoire de type statique à préchargement, caractérisé en ce qu'on prend une mémoire statique à accès aléatoire de type statique composée de transistors MOS constitutifs de l'ensemble des bascules mémoire, et en ce qu'on applique un faisceau de particules ou de photons à ces transistors MOS de manière à ce que la dose cumulée reçue soit supérieure à une valeur déterminée.

Pour obtenir une mémoire à accès aléatoire de type statique à préchargement, en utilisant un rayonnement gamma, la dose cumulée reçue doit, en général, être supérieure à plusieurs dizaines de kilorad (seuil variable selon les fabricants).

Brève description des figures

- La figure 1 illustre le fonctionnement du procédé de l'invention;

- la figure 2 représente un circuit permettant de mettre en oeuvre le procédé de l'invention.

Exposé détaillé du principe et d'un mode de réalisation

Un transistor MOS (Metal Oxyde Silicium) se dégrade plus vite sous l'effet de faisceaux de particules ou de photons lorsqu'il est passant. La dégradation avec ce type de composants se traduit par une dérive de sa tension de commande (Vgs). Cette dérive conduit au fait qu'après une exposition suffisante il n'est plus possible de bloquer un tel transistor.

Les mémoires CMOS volatiles de type statique sont composées de bascules elles-mêmes composées de transistors appartenant à cette famille. Si l'on positionne un bit à 0 ou à 1 dans un de ces composants alors qu'il est exposé à un faisceau de particules ou de photons :

- les transistors élémentaires d'une bascule mémoire qui sont passants dérivent plus rapidement vers cet état que ceux qui sont bloqués ;

- la bascule est alors figée dans l'état qu'elle possédait pendant son exposition.

Si on continue à l'exposer à ce faisceau, la bascule reste figée dans cet état jusqu'à ce que les transistors qui étaient bloqués se dégradent au point qu'il n'est plus possible de les maintenir bloqués.

Ainsi si, dans une mémoire volatile, on maintient le contenu souhaité alors que celle-ci est soumise suffisamment longtemps à un faisceau de particules ou de photons. Il est possible d'obtenir une mémoire à préchargement. La diminution du seuil de commande en saturation (Vgs) des transistors qui est plus rapide lorsque les transistors soumis au faisceau sont passants, déstabilise les bascules et a pour effet de les prépositionner à la mise sous tension avec le contenu qu'elles possédaient lors de cette irradiation. Cependant, il est encore possible de modifier leur contenu.

Pour qu'un composant mémoire permette l'exploitation du procédé de l'invention, il est nécessaire que les transistors, qui constituent les fonctions de décodage et l'adressage de la matrice mémoire, dérivent nettement moins vite que ceux des cellules mémoires.

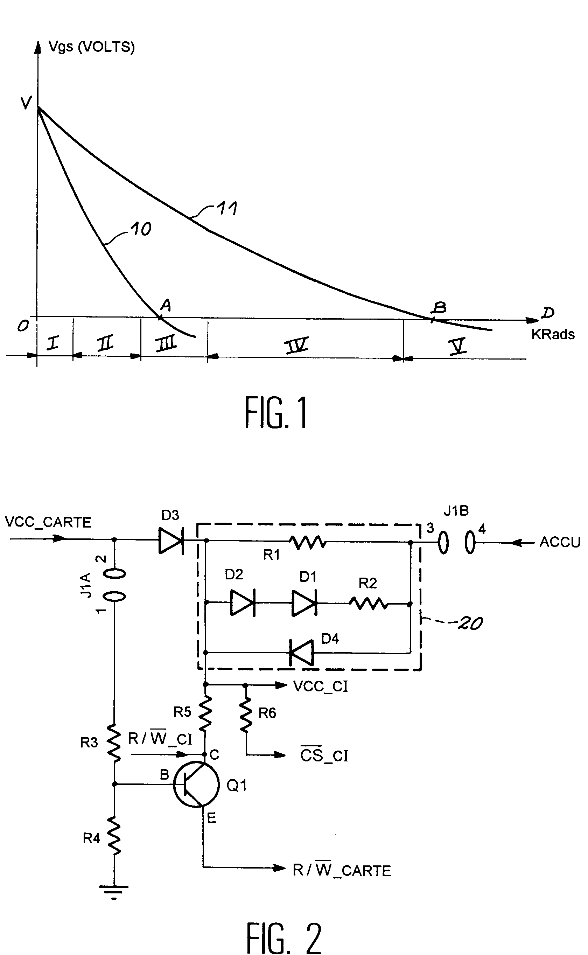

La figure 1 illustre les phases principales de la vie d'une mémoire volatile exposée à un faisceau de particules ou de photons en fonction de l'évolution de la tension de commande des transistors élémentaires MOS de type N. Pour un transistor de type P, l'allure de la courbe est identique avec un point de départ négatif.

Vgs est la tension qui fait passer le transistor MOS de l'état passant à l'état bloqué.

On a les différentes zones suivantes :

zone I :               RAM

zone II :              RAM à préchargement

zone III :            semi-figée

zone IV :            ROM

zone V :             inutilisable

La courbe 10 correspond à un transistor passant et la courbe 11 à un transistor bloqué.

Pour un composant complexe (plusieurs transistors étant combinés pour former par exemple une mémoire), de type mémoire UMC par exemple, avec un débit de dose de rayons gamma de 5 Krad/h on obtient les valeurs suivantes :
limite zone I - zone II # 63 Krad
limite zone III - zone IV # 630 Krad
limite zone IV - zone V > 1500 Krad
V # 2V

Il faut remarquer que la profondeur de pénétration dans la matière, liée à l'énergie mise en jeu, peut nécessiter de décapsuler les composants lors de leur exposition.

Conformément au procédé de l'invention, pour obtenir une mémoire RAM à préchargement, il est nécessaire d'exposer la mémoire RAM d'origine à un faisceau de particules ou de photons alors qu'elle contient les données que l'on souhaite y imprégner ou y figer.

La figure 2 illustre un exemple de carte permettant de mettre en oeuvre ce procédé. Les mémoires sont montées sur un support à accumulateur de manière à permettre le chargement et la sauvegarde de son contenu. Elles sont ensuite préchargées avec le contenu désiré puis exposées à un faisceau de particules ou de photons. Le débit de dose et la dose qu'elles subissent, pour pouvoir être utilisées en mémoires volatiles à prépositionnement à la mise sous tension, dépend du processus de fabrication mis en oeuvre. Ce paramètre dépend donc des composants utilisés et seul un essai préliminaire peut permettre de les déterminer.

Ce support, ou carte, comprend un transistor Q1 polarisé grâce à des résistances R3, R4 et R5.

Des branchements par cavalier J1A et J1B sont prévus entre la résistance R3 et l'alimentation carte Vcc_carte et entre l'accumulateur ACCU et un circuit de charge 20 relié à la résistance R5. Une diode D3 est reliée entre la tension d'alimentation carte et ce circuit de charge 20, et empêche l'accumulateur d'alimenter le reste de la carte.

On peut obtenir les signaux suivants :

- Vcc_CI : alimentation du circuit mémoire au point commun résistance R5 circuit 20;

- $\overline{CS}$ _CI : "Chip-Select" (patte de sélection) du circuit mémoire à l'extrémité d'une résistance R6 reliée au point commun précédent, R6 étant une résistance de mise à niveau haut du "Chip-Select" pour éviter que la mémoire ne soit sélectionnée;

- R/$\overline{W}$ _CI: écriture/lecture du circuit mémoire sur le collecteur du transistor Q1 ;

- R/$\overline{W}$ _Carte : écriture/lecture de la carte sur l'émetteur du transistor Q1.

On a un circuit de charge 20 à deux vitesses:

- à tension constante grâce aux diodes D1, D2 et à la résistance R2 ;

- à courant constant grâce à la résistance R1.

Le basculement de l'un à l'autre se fait automatiquement (seuil de 4,08 volts aux bornes des deux diodes D1 et D2).

La diode D4 permet l'alimentation du circuit mémoire lorsqu'il n'y a plus d'alimentation sur la carte.

Le circuit illustré sur la figure 2 assure différentes fonctions. Tout d'abord, il maintient la mémoire sous tension de manière à ce que son contenu soit sauvegardé une fois l'alimentation coupée. Le circuit de charge met automatiquement en charge l'accumulateur dès que le support est connecté sur une alimentation. Le système de polarisation assure que la mémoire n'est pas sélectionnée intempestivement en écriture. Ce système est complété par un cavalier qui par son absence interdit l'écriture de la mémoire.

Dans un exemple de réalisation:

R1 = 3,3 KΩ

R2 = 39Ω

R3 = R4 = 47 KΩ

R5 = 4,7 KΩ

R6 = 100 KΩ

D1 = D2 = D3 = diode 1N4148

D4 = diode BAT 48

Q1 = transistor BC549B

On pourrait, bien évidemment, utiliser d'autres circuits pour mettre en oeuvre le procédé de l'invention.

Ainsi la mémoire à programmer peut être montée sur une carte à micro contrôleur qui a pour fonction de maintenir dans cette RAM le contenu que l'on veut y mémoriser. On peut alors contrôler directement l'état d'imprégnation de la mémoire au fur et à mesure de son exposition.

L'invention permet de pouvoir disposer de circuits mémoires pouvant contenir des données ou des programmes résidents, modifiables.

La faisabilité du procédé de l'invention a été démontrée pour plusieurs modèles de mémoires soumises à un rayonnement gamma de cobalt 60.

Il est tout à fait envisageable de fabriquer des mémoires RAM qui posséderaient des caractéristiques les prédisposant à être utilisées avec ce procédé, en utilisant par exemple différentes technologies.

## Revendications

1. Procédé de production d'une mémoire à accès aléatoire de type statique à préchargement, caractérisé en ce qu'on prend une mémoire à accès aléatoire de type statique composée de transistors MOS constitutifs de l'ensemble des bascules mémoires, en ce qu'on applique un faisceau de particules ou de photons à ces transistors MOS de manière à ce que la dose cumulée reçue soit supérieure à une valeur déterminée.

2. Procédé selon la revendication 1, caractérisé en ce que pour obtenir une mémoire à accès aléatoire de type statique à préchargement, en utilisant un rayonnement gamma, la dose cumulée reçue doit être égale à plusieurs dizaines de kilorad.

3. Procédé selon la revendication 1, caractérisé en ce que la mémoire à accès aléatoire de type statique est montée sur un support à accumulateur de manière à permettre le chargement et la sauvegarde de son contenu, en ce qu'elle est ensuite préchargée avec le contenu désiré puis exposée à un faisceau de particules ou de photons, et en ce que le débit de dose et la dose qu'elle subit, pour pouvoir être utilisée en mémoire volatile à prépositionnement à la mise sous tension dépend du processus de fabrication mis en oeuvre.

4. Procédé selon la revendication 3, caractérisé en ce que le support maintient la mémoire sous tension de manière à ce que son contenu soit sauvegardé une fois l'alimentation coupée, en ce qu'un circuit de charge met automatiquement en charge l'accumulateur dès que le support est connecté sur une alimentation, en ce qu'un système de polarisation assure que la mémoire n'est pas sélectionnée intempestivement en écriture, en ce qu'un cavalier interdit par son absence l'écriture de la mémoire.

5. Procédé selon la revendication 1, caractérisé en ce que la mémoire RAM est montée sur une carte à micro-contrôleur qui a pour fonction de maintenir dans cette RAM le contenu que l'on veut y mémoriser, et en ce que l'on contrôle directement l'état d'imprégnation de la mémoire au fur et à mesure de son exposition.

Vgs (VOLTS)

FIG. 1

FIG. 2

Office européen
des brevets

**RAPPORT DE RECHERCHE EUROPEENNE**

Numero de la demande
EP 95 40 1981

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | IEEE TRANSACTIONS ON NUCLEAR SCIENCE, vol. 33, no. 6, NEW YORK US, pages 1484-1486, BRUCKER ET AL 'transient imprint memory effect in mos memories.' * le document en entier * | 1,2 | G11C7/00 G11C11/412 G11C17/14 G11C5/14 |
| A | ELECTRONICS DE 1984 A 1985 : ELECTRONICS WEEK., vol. 55, no. 23, NEW YORK US, pages 137-139, DAVIS ET AL 'high performance mos resists radiation.' * le document en entier * | 1,2 | |
| A | ELECTRONICS DE 1984 A 1985 : ELECTRONICS WEEK., vol. 58, no. 32, NEW YORK US, pages 32f/h-32j&l, PEARSON 'new rad-hard technology adds options for system designers.' * page 32H, colonne de droite, ligne 35 - page 32J, colonne de gauche, ligne 27 * | 1,2 | |
| A | US-A-4 418 402 (HEAGERTY) * colonne 2, ligne 38 - colonne 4, ligne 51; figures 1-3 * | 1 | |
| A | IBM TECHNICAL DISCLOSURE BULLETIN, vol. 27, no. 11, NEW YORK US, page 6368 'battery backup circuit for Cmos ram.' * le document en entier * | 4 | |
| A | EP-A-0 046 551 (SIEMENS) * le document en entier * | 1,4,5 | |

**DOMAINES TECHNIQUES RECHERCHES (Int.Cl.6)**

G11C

Le présent rapport a été établi pour toutes les revendications

| Lieu de la recherche | Date d'achèvement de la recherche | Examinateur |
|---|---|---|
| LA HAYE | 23 Janvier 1996 | Degraeve, L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)